(19) **Europäisches Patentamt / European Patent Office / Office européen des brevets**

(11) **EP 2 454 992 A1**

(12) **EUROPEAN PATENT APPLICATION**
published in accordance with Art. 153(4) EPC

(43) Date of publication:
**23.05.2012 Bulletin 2012/21**

(21) Application number: **10799750.4**

(22) Date of filing: **05.07.2010**

(51) Int Cl.:
***A61B 5/055*** (2006.01)

(86) International application number:
**PCT/JP2010/061391**

(87) International publication number:
**WO 2011/007691 (20.01.2011 Gazette 2011/03)**

(84) Designated Contracting States:
**AL AT BE BG CH CY CZ DE DK EE ES FI FR GB GR HR HU IE IS IT LI LT LU LV MC MK MT NL NO PL PT RO SE SI SK SM TR**

(30) Priority: **16.07.2009   JP 2009168059**

(71) Applicant: **Hitachi Medical Corporation**
**Chiyoda-ku**
**Tokyo 101-0021 (JP)**

(72) Inventors:
- **TAKIZAWA, Masahiro**
  **Tokyo 101-0021 (JP)**
- **MATSUDA, Yoshimasa**
  **Tokyo 101-0021 (JP)**
- **KAMADA, Yasuhiro**
  **Tokyo 101-0021 (JP)**

(74) Representative: **Strehl Schübel-Hopf & Partner**
**Maximilianstrasse 54**
**80538 München (DE)**

(54) **MAGNETIC RESONANCE IMAGING DEVICE AND MAGNETIC RESONANCE IMAGING METHOD**

(57)    In a non-Cartesian sampling method, a trajectory along which a measurement space is sampled is optimized. That is, data placed on one spiral trajectory heading outward from the center of the measurement space is sampled from a plurality of echo signals. The sampling is performed such that the data is placed continuously, without overlapping, in order from the center to the outside. Alternatively, the data may be overlapped and a mismatch between echo signals may be corrected using the data of the overlapped portion.

FIG. 6

EP 2 454 992 A1

**Description**

Technical Field

The present invention relates to a magnetic resonance imaging (hereinafter, abbreviated as "MRI") technique for acquiring a tomographic image of a target part of an object using a nuclear magnetic resonance (hereinafter, abbreviated as "NMR") phenomenon. In particular, the invention relates to a magnetic resonance imaging technique for acquiring such a tomographic image using a non-Cartesian sequence of sampling a measurement space in a non-parallel way and at unequal distances.

Background Art

In an MRI apparatus, when measuring an NMR signal (echo signal) generated by the object placed in the static magnetic field space and performing imaging, positional information is given to the echo signal using a gradient magnetic field. As the gradient magnetic field, a phase encoding gradient magnetic field for phase encoding of an echo signal and a frequency encoding gradient magnetic field, which is for frequency encoding and is also used for reading of an echo signal, are used. Measured echo signals become data, which occupies a measurement space (k space) specified by the strength of each gradient magnetic field, with one axis set in the phase encoding direction and the other axis set in the frequency encoding direction.

As a general imaging method, there is a Cartesian sampling method of repeating sampling, which is performed in parallel to the frequency encoding direction, in the phase encoding direction. In the Cartesian sampling method, when the object moves during imaging, the movement influences the entire image to cause an artifact (hereinafter, referred to as a "body motion artifact"), such as the streaming of an image in the phase encoding direction.

In contrast, there is an imaging method called a non-Cartesian sampling method of performing sampling by changing both the phase encoding gradient magnetic field and the frequency encoding gradient magnetic field for every measurement of one echo signal. As the non-Cartesian sampling method, there are a radial method (for example, refer to NPL 1), a spiral method (for example, refer to NPL 2), and the like.

The radial method is a technique of acquiring the data required for reconstructing one image by performing radial sampling while changing the rotation angle with approximately one point (generally, the origin) of the measurement space as the rotation center. On the other hand, the spiral method is a technique of acquiring the data required for reconstructing one image by performing spiral sampling while changing the rotation angle and the radius of rotation with approximately one point (generally, the origin) of the measurement space as the rotation center.

In the case of performing imaging using these non-Cartesian sampling methods, the sampling direction of each point is not aligned in one direction. Accordingly, body motion artifacts are scattered around an image. Since a body motion artifact protrudes to the outside of the field of view to be observed, the body motion artifact becomes less noticeable compared with imaging of the Cartesian sampling method. For this reason, the non-Cartesian sampling method is said to be robust against the body motion.

In addition, the spiral method is applied as a high-speed imaging method since less time is wasted when filling the measurement space and the data can be efficiently collected. In addition, a gradient magnetic field pulse waveform used when reading an echo signal is not a trapezoidal wave but a combination of a sine wave and a cosine wave. Therefore, the gradient magnetic field pulse waveform is efficient for the gradient magnetic field system, and there is little noise when applying a gradient magnetic field.

In addition, since fast Fourier transform is used for image reconstruction in the MRI, data needs to be placed at the coordinates on the regular grid of the measurement space. In the non-Cartesian sampling method, however, the data is not necessarily placed at the coordinates on the grid. Accordingly, the data is relocated at the coordinates on the grid using interpolation processing called gridding processing (for example, refer to NPL 3). The gridding processing is performed using a function for interpolation, such as a Sinc function or a Kaiser-Bessel function.

Citation List

Non Patent Literature

[NPL 1] G. H. Glover et. al., Projection Reconstruction Techniques for Reduction of Motion Effects in MRI, Magnetic Resonance in Medicine 28: 275-289 (1992)
[NPL 2] C. B. Ahn, High-Speed Spiral-Scan Echo Planar NMR Imaging-I, IEEE Trans. Med. Imag, 1986 vol MI-5 No. 1: 1-7

[NPL 3] J. I Jackson et. Al., Selection of a Convolution Function for Fourier Inversion Using Gridding, IEEE Trans. Med. Imaging. vol. 10, pp. 473-478, 1991

Summary of Invention

Technical Problem

In both the radial method and the spiral method, sampling density near the center of the measurement space is high since echo signals are collected by setting one point of the measurement space as the rotation center. For this reason, the absolute amount of artifacts is further reduced due to the data addition effect. However, the imaging time becomes long since the number of echo signals required for filling the measurement space is increased compared with the Cartesian sampling method.

In the spiral method, imaging efficiency can be increased by filling the entire measurement space by one shot using the single-shot method, for example. However, if the number of points acquired by one shot is increased, sampling time of an echo signal becomes long. Accordingly, since a chemical shift, a contrast reduction, or image distortion due to magnetic field susceptibility occurs, the image quality is degraded.

In order to avoid such degradation of the image quality, there is a technique of filling the measurement space by shortening one sampling time using the multi-shot method. Here, data on a spiral trajectory which differs with each shot is acquired. In this way, the degradation of the image quality can be suppressed. In addition, since a low spatial frequency region near the origin of the measurement space is repeatedly acquired, body motion artifacts are suppressed by the addition effect. However, imaging efficiency is not improved. In addition, echo signals at different times are placed in a central portion of the measurement space. Accordingly, when the motion of the object is not made periodically or when the motion of the object is large, the obtained image becomes an image in which images with different shapes are mixed.

The invention has been made in view of the above-described situation, and it is an object of the invention to improve the image quality without degrading the imaging efficiency while suppressing body motion artifacts when acquiring an image in an MRI.

Solution to Problem

The invention is to optimize a trajectory, along which a measurement space is sampled, in a non-Cartesian sampling method. Data placed on one spiral trajectory heading outward from the center of the measurement space is sampled from a plurality of echo signals.

Specifically, there is provided a magnetic resonance imaging apparatus including: a high frequency magnetic field irradiating unit that irradiates a high frequency magnetic field causing nuclear magnetic resonance in nuclear spins in an object; a data collector that detects an echo signal irradiated by the nuclear magnetic resonance while applying a read gradient magnetic field and placing the echo signal as data in a measurement space; and a controller that controls operations of the high frequency magnetic field irradiating unit and the data collector and characterized in that the controller controls the data collector to collect data, which is placed on one spiral trajectory heading outward from the center of the measurement space, from the plurality of echo signals.

In addition, there is provided a magnetic resonance imaging method including: a data collection step of collecting data, which is placed on one spiral trajectory heading outward from the center of a measurement space, from a plurality of echo signals irradiated by nuclear magnetic resonance so as to fill the measurement space without overlapping; and an image reconstruction step of reconstructing an image from the data of the measurement space collected in the data collection step. Advantageous Effects of Invention

According to the invention, it is possible to improve the image quality without degrading the imaging efficiency while suppressing body motion artifacts when acquiring an image in an MRI.

Brief Description of Drawings

[Fig. 1] Fig. 1 is a block diagram showing the entire configuration in an example of an MRI apparatus of a first embodiment.

[Fig. 2] Fig. 2 is a view for explaining the pulse sequence of a radial method.

[Fig. 3] Fig. 3(a) is a view for explaining the arrangement of the measurement space by the radial method, and Fig. 3(b) is a view for explaining the arrangement of the measurement space by a single-shot spiral method.

[Fig. 4] Fig. 4 is a view for explaining the pulse sequence of a spiral method.

[Fig. 5] Fig. 5(a) is a view for explaining the arrangement of the measurement space by a multi-shot spiral method, and Fig. 5(b) is a view for explaining a waveform of a read gradient magnetic field in each shot.

[Fig. 6] Figs. 6(a) to 6(d) are views for explaining read gradient magnetic field waveforms and the arrangement of the measurement space in each shot in the sampling method of the first embodiment.

[Fig. 7] Figs. 7(a) to 7(d) are views for explaining read gradient magnetic field waveforms and the arrangement of the measurement space in each shot in the sampling method of a second embodiment.

[Fig. 8] Fig. 8 is a view for explaining the relaxation of magnetization of an MRI.

[Fig. 9] Fig. 9 is a view of the pulse sequence when a sampling method of a third embodiment is applied to a multi-echo method.

[Fig. 10] Fig. 10(a) is a view for explaining the arrangement of the measurement space when the third embodiment is applied to a single-shot method, and Fig. 10(b) is a view for explaining the arrangement of the measurement space when the third embodiment is applied to a multi-shot method.

[Fig. 11] Figs. 11(a) and 11(b) are views for explaining the screen configuration of a setting screen of a fourth embodiment.

[Fig. 12] Figs. 12(a) to 12(c) are views for explaining an example of the invention.

Description of Embodiments

«First embodiment»

Hereinafter, a first embodiment to which the invention is applied will be described. Hereinafter, in all drawings for explaining the embodiments of the invention, the same reference numerals are given to elements with the same functions, and repeated explanation thereof will be omitted.

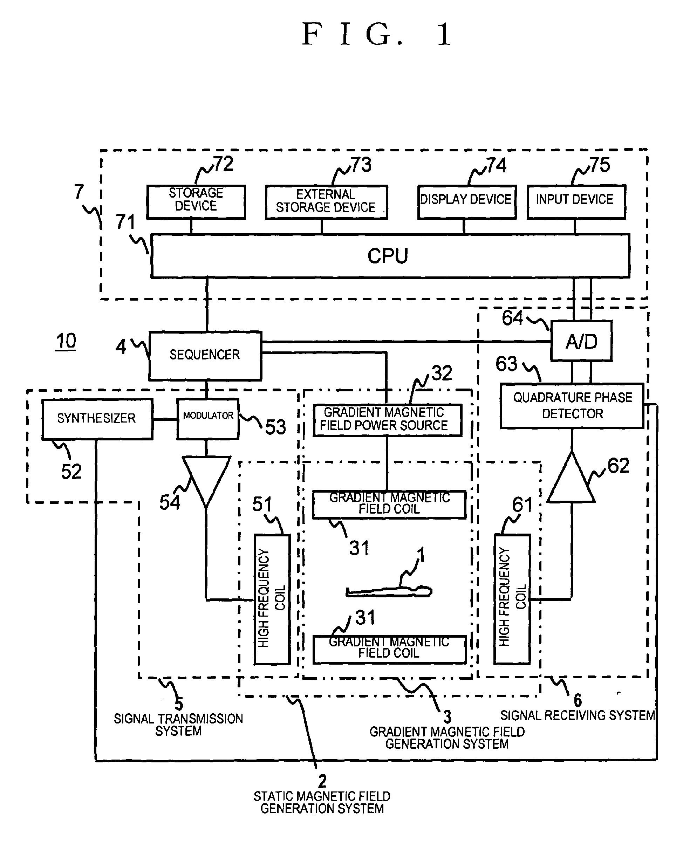

Fig. 1 is a block diagram showing the entire configuration in an example of an MRI apparatus 10 of the present embodiment. This MRI apparatus 10 acquires a tomographic image of an object 1 using an NMR phenomenon. As shown in Fig. 1, the MRI apparatus 10 includes a static magnetic field generation system 2, a gradient magnetic field generation system 3, a sequencer 4, a signal transmission system 5, a signal receiving system 6, and an information processing system 7.

The static magnetic field generation system 2 generates a uniform static magnetic field in the space around the object 1 in the body axis direction or a direction perpendicular to the body axis. The static magnetic field generation system 2 includes permanent magnet type, normal conduction type, or superconduction type magnetic field generation unit disposed around the object 1.

The gradient magnetic field generation system 3 includes a gradient magnetic field coil 31 wound in three axial directions of X, Y, and Z and a gradient magnetic field power source 32 which drives each gradient magnetic field coil 31. The gradient magnetic field power source 32 drives each gradient magnetic field coil 31 according to the command from the sequencer 4, which will be described later, to apply gradient magnetic fields Gs, Gp, and Gf in the three axial directions of X, Y, and Z to the object 1. The slice plane for the object 1 is set by the slice-direction gradient magnetic field pulse (Gs) applied in one direction of X, Y, and Z, and positional information in each direction is encoded in an echo signal by a phase-encoding-direction gradient magnetic field pulse (Gp) and a frequency-encoding-direction gradient magnetic field pulse (Gf) applied in the remaining two directions.

The sequencer 4 applies a high frequency magnetic field pulse (hereinafter, referred to as an "RF pulse") and a gradient magnetic field pulse repeatedly according to the predetermined pulse sequence. The sequencer 4 operates by control of a CPU 71 provided in the information processing system 7 and transmits various commands, which are required for data collection of the tomographic image of the object 1, to the signal transmission system 5, the gradient magnetic field generation system 3, and the signal receiving system 6.

The signal transmission system 5 irradiates RF pulses in order to cause nuclear magnetic resonance in the nuclear spins of atoms which form the body tissue of the object 1. The signal transmission system 5 includes a high frequency oscillator (synthesizer) 52, a modulator 53, a high frequency amplifier 54, and a transmission-side high frequency coil (transmission coil) 51. An RF pulse output from the high frequency oscillator 52 is amplitude-modulated by the modulator 14 at the timing based on a command from the sequencer 4. The amplitude-modulated RF pulse is amplified by the high frequency amplifier 54 and is then supplied to the transmission coil 51 disposed near the object 1. Then, the RF pulse (electromagnetic wave) from the high frequency coil 51 is irradiated to the object 1.

The signal receiving system 6 detects an echo signal (NMR signal) irradiated by the nuclear magnetic resonance of the nuclear spins which form the body tissue of the object 1. The signal receiving system 6 includes a receiving-side high frequency coil (receiving coil) 61, an amplifier 62, a quadrature phase detector 63, and an A/D converter 64. An electromagnetic wave (NMR signal) of the response induced by the electromagnetic wave irradiated from the transmission coil 51 is detected by the receiving coil 61 disposed near the object 1. The detected NMR signal is amplified by the amplifier 62 and is then divided into two orthogonal signals by the quadrature phase detector 63 at the timing based on the command from the sequencer 4. Each of the orthogonal signals is converted into the digital amount by the A/D converter 64 and is transmitted to the information processing system 7.

In addition, in Fig. 1, the transmission coil 51, the receiving coil 61, and the gradient magnetic field coil 31 are provided in the static magnetic field space formed by the static magnetic field generation system 2 disposed in the space around the object 1.

The information processing system 7 includes the CPU 71, a storage device 72, an external storage device 73 such as an optical disc or a magnetic disk, a display device 74 such as a display, and an input device 75 such as a mouse or a keyboard. When the data from the signal receiving system 6 is input, the CPU 71 executes processing, such as signal processing and image reconstruction, and displays a tomographic image of the object 1, which is the result, on the display device 74 and also records it in the storage device 72 and/or the external storage device 73.

A spin kind to be imaged by the MRI apparatus 10 which is widely used clinically at present is a proton which is a main constituent material of the object 1. The MRI apparatus 10 photographs the shapes or functions of the head, abdomen, limbs, and the like of the human body in a two-dimensional or three-dimensional manner by imaging the spatial distribution of proton density or the spatial distribution of excited-state relaxation phenomenon.

In addition, data collection for reconstructing the tomographic image is performed according to the pulse sequence and an imaging parameter required for controlling the pulse sequence. The pulse sequence includes an imaging sequence part for determining the contrast of a tomographic image and the like, which includes the application of an RF pulse for excitation, and a data collection sequence part for sampling an echo signal generated by the application of the RF pulse for excitation and filling it in the measurement space. The pulse sequence is created in advance and is stored in the storage device 72 and/or the external storage device 73, and the imaging parameter is input through the input device 75 from the operator and is stored in the storage device 72 and/or the external storage device 73. The CPU 71 gives an instruction to the sequencer 4 according to the pulse sequence and the imaging parameter to realize this.

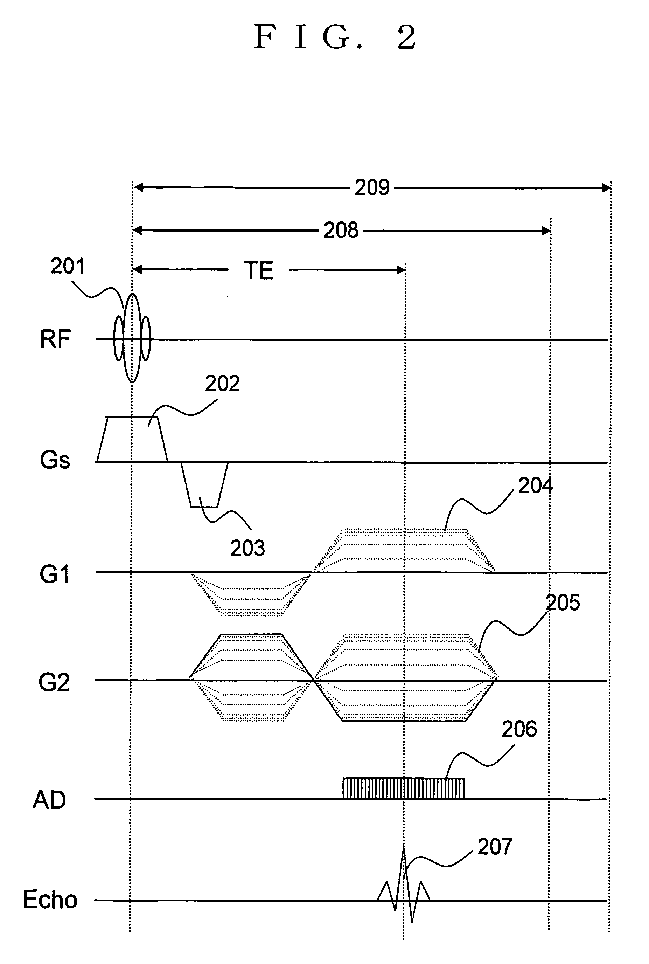

The data collection sequence part of the present embodiment is for collecting (sampling), from a plurality of echo signals, the data on one spiral trajectory in the measurement space. Before explaining a sampling method realized by the data collection sequence part of the present embodiment, a general non-Cartesian sampling method will be described. Fig. 2 shows an example of the pulse sequence of a radial pulse sequence method among non-Cartesian sampling methods.

In Fig. 2, RF, Gs, G1, G2, AD, and echo indicate axes of an RF pulse, a slice gradient magnetic field, a read gradient magnetic field in a first direction, a read gradient magnetic field in a second direction, A/D conversion, and an echo signal, respectively. In addition, 201 is an RF pulse for excitation, 202 is a slice selection gradient magnetic field pulse, 203 is a slice re-phase gradient magnetic field pulse, 204 is a first read gradient magnetic field pulse, 205 is a second read gradient magnetic field pulse, 206 is a sampling window, 207 is an echo signal, and 208 is a repetition time (irradiation interval of the RF pulse 201). In addition, processing (called a shot) from irradiation of the RF pulse 201 to measurement of the echo signal 207 is repeated every repetition interval 208 while changing the strengths of the first and second read gradient magnetic field pulses 204 and 205 in each shot, so that data required for reconstructing one image for an image acquisition time 209 is sampled from the measured echo signal 207.

In the radial method, data is collected by sampling an echo signal, which is irradiated from the nuclear spins excited by an arbitrary RF pulse excitation method, along the radial trajectory with approximately one point (generally, the center of the measurement space) of the measurement space as the center. In order to realize such collection of data, an echo signal is sampled while applying pulses with waveforms, which are expressed as $G_1(t)$ and $G_2(t)$ in the following Expression (1), as the first and second read gradient magnetic field pulses 204 and 205.

$$[\text{Expression 1}]$$

$$G_1(t) = G_f(t)\cos\theta$$

$$G_2(t) = G_f(t)\sin\theta \ \dots \ (1)$$

Here, $G_f$ is a read gradient magnetic field pulse waveform used in the Cartesian sampling method, $\theta$ is an angle of rotation of an echo signal, which is measured every repetition time 208, in the measurement space, and t is an application time ($1 \leq t \leq T$) of a read gradient magnetic field pulse. Here, T is a sampling time. Generally, since an echo signal is sampled in a section where the strength of the read gradient magnetic field pulse is fixed, $G_f$ does not depend on time. Therefore, $G_f(t)$ is expressed as a constant G as shown in the following Expression (2).

[Expression 2]

$$G_f(t) \equiv G \quad \dots \quad (2)$$

In the MRI, there is the relationship expressed by the following Expression (3) between an output of the read gradient magnetic field pulse and the coordinates of the measurement space.

[Expression 3]

$$k(t) = \chi \int_0^t G(t')dt' \quad \dots \quad (3)$$

Here, $\gamma$ is a gyromagnetic ratio.

Accordingly, from the Expressions (1), (2), and (3), the coordinates ($k_x(t)$, $k_y(t)$) of the measurement space where the data sampled from the echo signal 207 measured after the time t from the application of the RF pulse 201 is placed are expressed by the following Expression (4).

[Expression 4]

$$k_x(t) = \gamma \cdot G \cdot t \cdot \cos\theta$$

$$k_y(t) = \gamma \cdot G \cdot t \cdot \sin\theta \quad \dots \quad (4)$$

In addition, the measurement space is generally expressed with the vertical axis as Ky and the horizontal axis as Kx. Here, $G_1$ and $G_2$ in Expression (1) are set as $G_x$ and $G_y$, respectively, and the corresponding coordinates $k_x$ and ky are calculated. The following is similar.

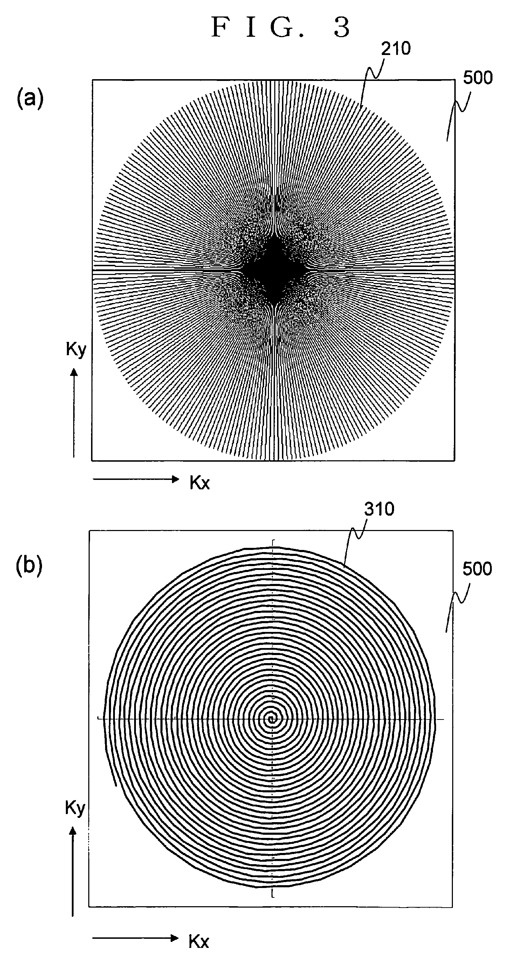

As described above, when the echo signal 207 is sampled while applying the pulses with waveforms, which are expressed as $G_1(t)$ and $G_2(t)$ in the following Expression (1), as the first and second read gradient magnetic field pulses 204 and 205, data is placed on a linear trajectory which passes through the origin of the measurement space and has an angle $\theta$ with respect to the X axis. A trajectory 210 of the measurement space 500 in this case is shown in Fig. 3(a). Data is placed on the linear trajectory 210 spreading radially around the origin.

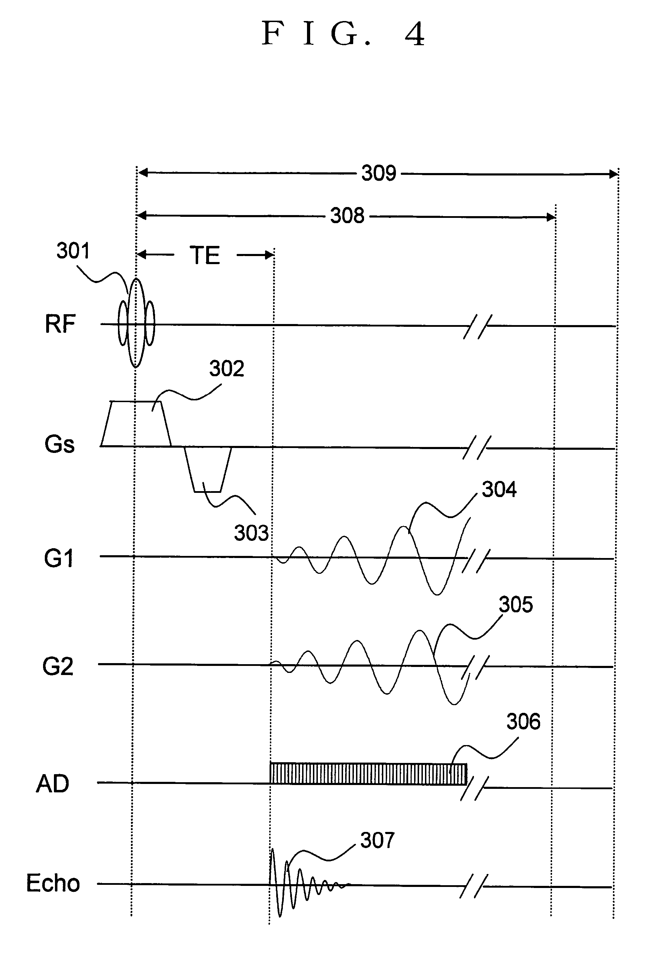

Next, a pulse sequence (spiral sequence) based on a spiral method is shown in Fig. 4 as another example of the non-Cartesian sampling method. In Fig. 4, RF, Gs, G1, G2, AD, and echo indicate the axes of an RF pulse, a slice gradient magnetic field, a read gradient magnetic field in the first direction, a read gradient magnetic field in the second direction, A/D conversion, and an echo signal, respectively. In addition, 301 is an RF pulse for excitation, 302 is a slice selection gradient magnetic field pulse, 303 is a slice re-phase gradient magnetic field pulse, 304 is a first read gradient magnetic field pulse, 305 is a second read gradient magnetic field pulse, 306 is a sampling window, 307 is an echo signal, and 308 is a repetition time (irradiation interval of the RF pulse 301). Also in this case, processing (shot) from irradiation of the RF pulse 301 to measurement of the echo signal 307 is repeated every repetition interval 308 while changing the strengths of the first and second read gradient magnetic field pulses 304 and 305 in each shot, so that data required for reconstructing one image for an image acquisition time 309 is sampled from the measured echo signal 307.

In the spiral method, data is collected by sampling an echo signal, which is irradiated from the nuclear spins excited by an arbitrary RF pulse excitation method, along the spiral trajectory with approximately one point (generally, the center of the measurement space) of the measurement space as the center. In order to realize such collection of data, an echo signal is sampled while applying pulses with waveforms, which are expressed as $G_1(t)$ and $G_2(t)$ in the following Expression (5), as the first and second read gradient magnetic field pulses 304 and 305.

[Expression 5]

$$G_1(t) = \eta\cos\zeta t - \eta\zeta t\sin\zeta t$$

$$G_2(t) = \eta\sin\zeta t + \eta\zeta t\cos\zeta t \ldots (5)$$

Here, $\eta$ and $\zeta$ are constants set in advance.

Accordingly, from the Expressions (3) and (5), the coordinates $(k_x(t), k_y(t))$ of the measurement space where the data sampled from the echo signal 307 measured after the time t from the application of the RF pulse 301 is placed are expressed by the following Expression (6).

[Expression 6]

$$k_x(t) = \gamma\eta t\cos\zeta t$$

$$k_y(t) = \gamma\eta t\sin\zeta t \ldots (6)$$

As described above, when the echo signal 307 is sampled while applying the pulses with waveforms, which are expressed as $G_1(t)$ and $G_2(t)$ in the following Expression (5), as the first and second read gradient magnetic field pulses 304 and 305, data is placed on a spiral trajectory heading outward from the origin of measurement space. A spiral trajectory 310 of the measurement space 500 in this case is shown in Fig. 3(b).

As the spiral method, there are not only the above-described method (single-shot spiral method) of sampling all data items, which are required for reconstructing one image from one echo signal obtained by one shot, but also a method (multi-shot spiral method) of sampling data, which is required for reconstructing one image from a plurality of echo signals, by performing a shot multiple times. In the multi-shot spiral method, the above-described spiral sequence is repeated every repetition interval 308 while changing the strengths of the first and second read gradient magnetic field pulses 304 and 305 in each shot, so that the data required for reconstructing one image for the image acquisition time 309 is collected. By changing the strengths of the first and second read gradient magnetic field pulses 304 and 305 in each shot, data on a plurality of different spiral trajectories rotating around the origin is collected.

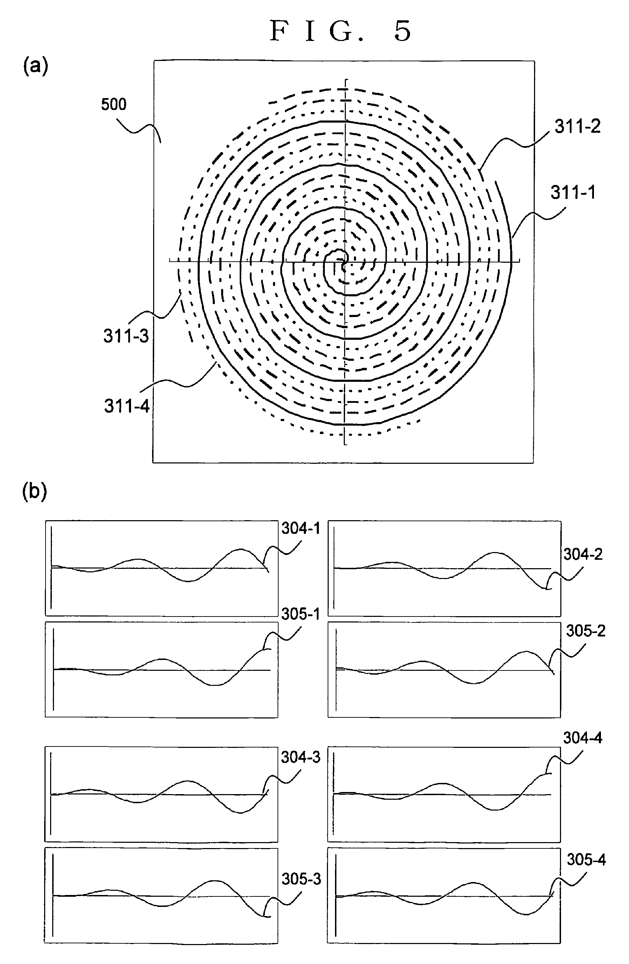

Fig. 5(a) shows a state of filling of the measurement space 500 in the multi-shot spiral method, and Fig. 5(b) shows first and second read gradient magnetic fields applied in each shot. Here, a case where a region of the measurement space 500 is filled by four shots is shown as an example.

As shown in this drawing, in the multi-shot spiral method, strengths of first read gradient magnetic field pulses 304-1, 304-2, 304-3, and 304-4 and second read gradient magnetic field pulses 305-1, 305-2, 305-3, and 305-4 applied in each shot are changed, as shown in Fig. 5(b). Then, in each shot, data on a plurality of different spiral trajectories 311-1, 311-2, 311-3, and 311-4 heading outward from the center in the measurement space 500 is acquired, and a region of the measurement space 500 required for reconstructing an image is filled. The spiral trajectories are expressed as a solid line 311-1, a dashed line 311-2, a dot-dash line 311-3, and a broken line 311-4. Numbers after a hyphen correspond to shot numbers (1 to 4) given to each shot.

In the single-shot spiral method, a data acquisition period (width of the sampling window 306) required for filling the measurement space becomes long. The typical data acquisition period is tens of milliseconds. Image distortion caused by non-uniformity of the static magnetic field, magnetic field susceptibility, or the like increases in proportion to the data acquisition period. For this reason, an image is easily distorted in the single-shot spiral method. In this respect, in the multi-shot spiral method, total imaging time increases but the data acquisition period of each shot becomes short. Accordingly, image distortion is reduced.

On the other hand, main shape and contrast of an image are determined by the information on a central section of the measurement space. In the multi-shot spiral method, data sampled from echo signals at different times is placed in the central portion of the measurement space. For this reason, since images with different time phases may be mixed in the central portion of the measurement space, blurring may occur. In addition, if the multi-echo method is used together, data sampled from all acquired echo signals is placed near the center of the measurement space. For this reason, the contrast of an image may be reduced.

In the present embodiment, the feature of the non-Cartesian sampling method that an artifact is reduced is maintained so that both the image quality and imaging efficiency are satisfied. Therefore, in the present embodiment, when acquiring a plurality of echo signals in the multi-shot method, sampling is performed using the non-Cartesian sampling method. In this case, sampling is performed such that all data items are placed on the same one spiral trajectory heading outward from the center of the measurement space. Hereinafter, a sampling method of the data collection sequence part of the present embodiment which realizes this will be described.

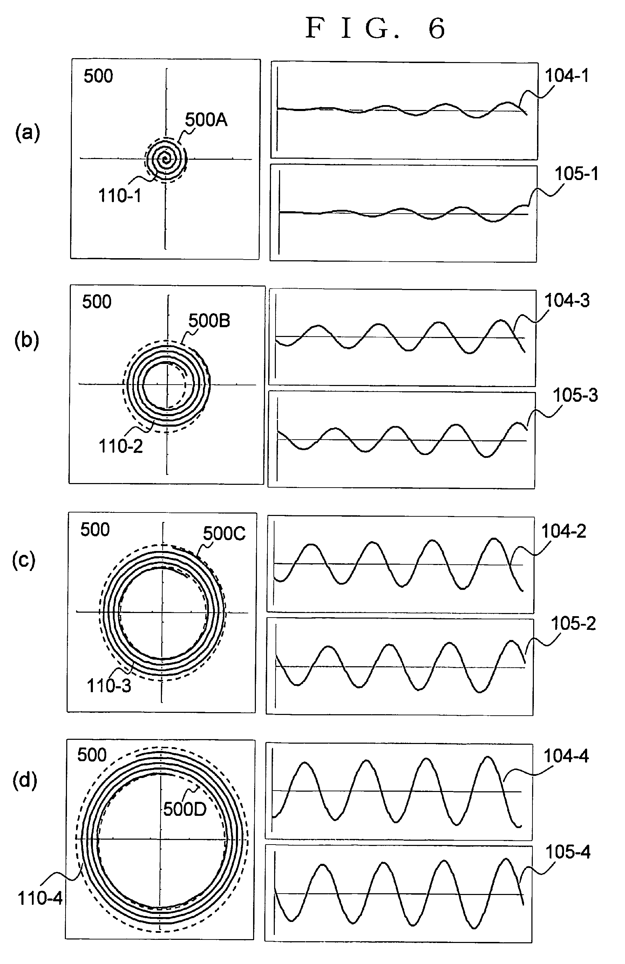

Fig. 6 is a view for explaining a read gradient magnetic field waveform of the sampling method of the present embodiment and a trajectory of the measurement space based on the read gradient magnetic field waveform. Basically, the sampling method of the present embodiment is based on the spiral method. That is, the pulse sequence shown in Fig. 4 is repeated every repetition interval 308 while changing the strengths of the first and second read gradient magnetic field pulses 304 and 305 in each shot, so that an echo signal required for reconstructing one image for the image acquisition time 309 is acquired. Unlike the spiral method in the related art, according to the sampling method of the present embodiment, data is placed on a trajectory in a region where the distance from the center of the measurement space differs with each shot. Here, a case where the number of shots is 4 is illustrated.

Figs. 6(a) to 6(d) show waveforms of the first read gradient magnetic field pulse $G_1$ (Gx) 104 and the second read gradient magnetic field pulse $G_2$ (Gy) 105 and an acquired trajectory 110 of the measurement space 500 in each shot. The trajectory in an s-th shot and the first and second read gradient magnetic field pulses $G_1$ and $G_2$ are expressed as 110-s, 104-s, and 105-s ($1 \leq s \leq 4$), respectively. In addition, when it is not necessary to distinguish them specially, parts after a hyphen are omitted.

In the present embodiment, sampling is performed while applying each of the first and second read gradient magnetic fields G1 and G2 such that a region required for reconstructing an image of the measurement space 500 is filled by trajectories 110-1, 110-2, 110-3, and 110-4 acquired by four shots. In this case, waveforms of gradient magnetic field pulses used as the first and second read gradient magnetic field pulses 104-s and 105-s in the s-th shot are expressed as $G_1(t',s)$ and $G_2(t',s)$ in the following Expression (7), respectively.

[Expression 7]

$$G_1(t',s) = \eta\cos\zeta\tau(t',s) - \eta\zeta\tau(t',s)\sin\zeta\tau(t',s)$$

$$G_2(t',s) = \eta\sin\zeta\tau(t',s) + \eta\zeta\tau(t',s)\cos\zeta\tau(t',s) \quad \dots \quad (7)$$

Here, t' is an application time of the first and second read gradient magnetic field pulses 104 and 105. Here, since the multi-shot method in which the number of shots is 4 is used, t' is a time of 1/4 of total application time T of each read gradient magnetic field pulse when sampling an echo signal obtained by the single-shot method using the spiral method ($1 \leq t' \leq T/4$). In addition, $\tau(t',s)$ is expressed by the following Expression (8).

[Expression 8]

$$\tau(t',s) = \frac{(s-1)}{4} \times T + t' \quad \dots \quad (8)$$

In addition, when the number of shots is n (n is an integer of 1 or more), the above Expression (8) is expressed by the following Expression (9).

[Expression 9]

$$\tau(t',s) = \frac{(s-1)}{n} \times T + t' \quad \dots \quad (9)$$

Here, $1 \leq t' \leq T/n$.

In the multi-shot method, by performing sampling while applying the first and second read gradient magnetic fields $G_1$ and $G_2$ having the waveforms expressed by the above-described Expressions (7) and (8) in each shot s, data on the trajectories 110-1, 110-2, 110-3, and 110-4 of the measurement space 500 shown in Figs. 6(a) to 6(d), respectively, in each shot s is placed. When these are combined together, data on one spiral trajectory in the measurement space 500 is acquired without overlapping. That is, data of regions (segments) 500A, 500B, 500C, and 500D which are surrounded by concentric circles having the center of the measurement space as each center and are shown in Figs. 6(a) to 6(d), respectively, can be acquired in each shot s. Accordingly, a region of the entire measurement space can be filled by all shots (here, four shots). In the present embodiment, an image is reconstructed using the data in the measurement space acquired in this way.

As described above, according to the present embodiment, since the measurement space is scanned basically in the same manner as in the spiral method in the related art, the reduction in an artifact which is the feature of the non-Cartesian sampling method can be maintained. In addition, since measurement is performed using the multi-shot method, each sampling time is short as in the multi-shot spiral method in the related art. For this reason, a chemical shift, a contrast reduction, or the occurrence of image distortion due to magnetic field susceptibility can be suppressed.

In addition, in the present embodiment, sampling is not performed along the trajectory starting from the origin in each shot unlike the multi-shot spiral method in the related art. Accordingly, the central portion of the measurement space is not measured in each shot. That is, according to the present embodiment, data is placed without overlapping on one spiral trajectory of the measurement space even though measurement is performed by the multi-shot method. For this reason, imaging efficiency is not reduced, either. In addition, since the central portion of the measurement space having a large effect on the contrast and shape of an image is formed by the data acquired by one shot, a contrast reduction or image blurring, which occurs because images with different time phases are mixed, can be suppressed.

Therefore, according to the present embodiment, not only the effect of the multi-shot spiral method in the related art but also the effect of suppressing the occurrence of image blurring without degrading the imaging efficiency can be obtained. That is, according to the present embodiment, it is possible to acquire a high-quality MRI image without degrading the imaging efficiency while suppressing the body motion artifact.

In addition, according to the present embodiment, one application time (sampling time) of the read gradient magnetic field pulse becomes short as the number of shots increases. Therefore, according to the present embodiment, the application time (sampling time) of the read gradient magnetic field pulse in each shot can also be made equal to that in the Cartesian sampling method by adjusting the number of shots. In this case, start and end points of the trajectory of the measurement space become close to the center of the measurement space relatively compared with that in the case of the Cartesian sampling method. Therefore, since the amplitude of a read gradient magnetic field pulse to be used becomes small, noise at the time when the gradient magnetic field pulse is applied can be reduced.

In addition, in the embodiment described above, sampling is performed while applying the first and second read gradient magnetic field pulses having the waveforms based on Expressions (7) and (8). However, waveforms of the read gradient magnetic field pulses applied at the time of sampling are not limited to these. Preferably, waveforms of the first and second read gradient magnetic field pulses vibrate and amplitudes of the first and second read gradient magnetic field pulses increase gradually or decreases gradually, and the strength at the end point in (s-1)-th application and the strength at the start point in s-th application are equal so that the trajectory of the measurement space acquired by the first and second read gradient magnetic field pulses is spiral.

«Second embodiment»

Hereinafter, a second embodiment to which the invention is applied will be described. An MRI apparatus of the present embodiment is basically the same as that in the first embodiment. In addition, also in the present embodiment, the image quality is improved without lowering imaging efficiency while maintaining the features of non-Cartesian sampling as in the first embodiment. In the present embodiment, a function of correcting a data mismatch occurring between the shots is provided. Hereinafter, the present embodiment will be described focusing on the different configuration from the first embodiment.

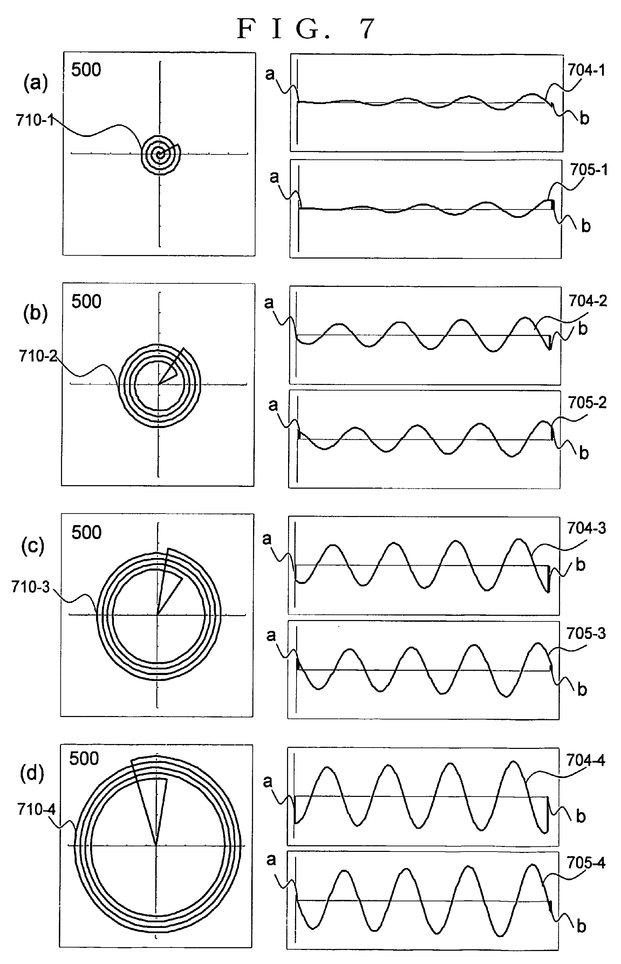

Fig. 7 is a view for explaining a read gradient magnetic field waveform of the sampling method of the present embodiment and a trajectory of the measurement space based on the read gradient magnetic field waveform. Basically, the sampling method of the present embodiment is also based on the spiral method in the same manner as in the first embodiment. The sampling method of the present embodiment is different from the sampling method of the first embodiment in that an application time and a sampling window (sampling time) of the first and second read gradient magnetic field pulses are the same. Hereinafter, a sampling method of the data collection sequence part of the present embodiment which realizes this will be described.

Also in the present embodiment, a case where the number of shots is 4 is illustrated as in the first embodiment. Figs. 7(a) to 7(d) show waveforms of a first read gradient magnetic field pulse $G_1$ (Gx) 704 and a second read gradient magnetic field pulse G₂ (Gy) 705 and an acquired trajectory 710 of the measurement space in each shot. The trajectory in an s-th shot and the read gradient magnetic field pulses G₁ and G₂ are expressed as 710-s, 704-s, and 705-s (1 ≤ s ≤ 4), respectively. In addition, when it is not necessary to distinguish them specially, parts after a hyphen are omitted.

In the present embodiment, data sampling starts from the point of time when first and second read gradient magnetic field pulses 701 and 702 are applied, and the data sampling continues until the end of the application of both the read gradient magnetic field pulses. Therefore, the waveforms of the first and second read gradient magnetic field pulses 701 and 702 within the imaging plane of the present embodiment have the same shape as in the first embodiment during data sampling except for immediately after the start and immediately before the end (refer to Expressions (7) and (8)). However, a rising part a immediately after the start and a falling part b immediately before the end are provided.

For this reason, data placed in a spiral trajectory portion of 701-s in Figs. 7(a) to 7(d) is sampled while parts of the first and second read gradient magnetic field pulses 701 and 702 having the waveforms expressed by Expressions (7) and (8) are being applied. In addition, data placed on the linear trajectory, which makes a connection between the origin of the measurement space and the start point of the spiral trajectory portion, is sampled while the rising parts a of the gradient magnetic field pulses 701 and the second read gradient magnetic field pulse 702 are being applied. In addition, data placed on the linear trajectory, which makes a connection between the origin of the measurement space and the end point of the spiral trajectory portion, is sampled while the falling part b is being applied.

In the present embodiment, sampling is performed in this way in all shots s so that data on the straight line heading outward from the origin is acquired between the shot s and the last shot (shot number s-1: (s-1)-th shot).

In the present embodiment, in the information processing system 7, a data mismatch occurring between the shots is corrected by comparing the data on this linear trajectory. Examples of a mismatch of data to be corrected include a mismatch caused by a change in the signal strength due to relaxation of magnetization, discontinuities of echo signals caused by body motion of the object, and the like.

An MRI signal attenuates with time according to the following Expression (10) after being excited by irradiation of an RF pulse.

[Expression 10]

$$S(t) = \alpha \times e^{\frac{1}{T^2}} \quad \dots \quad (10)$$

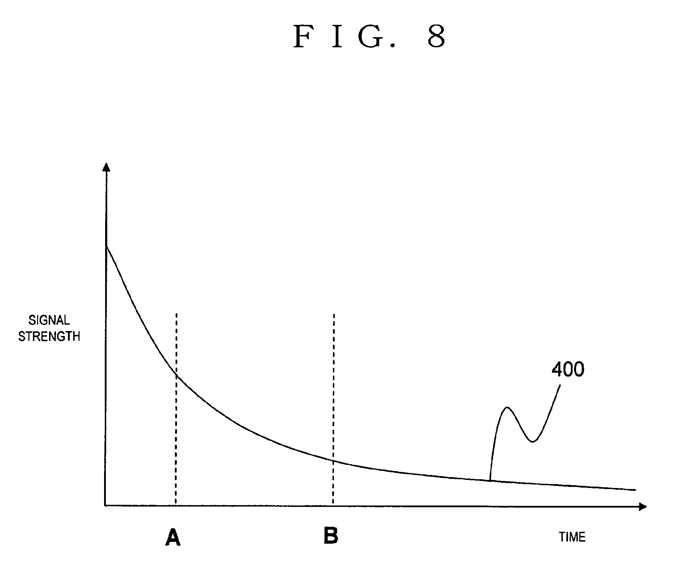

Here, α is a constant, and T2 is a relaxation time of tissue. Fig. 8 shows a relaxation curve 400 showing a state of attenuation. In this case, an echo signal sampling time is determined by an echo time (TE) and the number of data points to be sampled, which are designated as imaging parameters. Fig. 8 is an example of sampling the data between times A and B. In Fig. 8, as a time between A and B becomes long, a signal value difference by attenuation becomes large.

Therefore, in the present embodiment, a data mismatch caused by a change in the signal strength due to relaxation of magnetization is corrected by comparing a change in the signal strength at the end of signal measurement in the (s-1) -th shot with a change in the signal strength at the start of signal measurement in the s-th shot. That is, in the present embodiment, trajectories in the same measurement space are acquired at both the times. The amount of attenuation from the start of signal measurement to the end of signal measurement is specified by comparing these signal strengths with each other. Then, the amplitude is corrected such that the specified amount of attenuation becomes 0.

In addition, discontinuities of echo signals caused by body motion of the object or the like occur as a change in the phase or amplitude of an echo signal in many cases. In this case, correction is performed such that a phase difference between the shots at the same coordinates of the measurement space in the linear data becomes 0 and an amplitude change between the shots in the linear data becomes 0.

The amplitude correction is performed in the same procedure. In addition, the phase difference correction is to calculate the phase difference between the shots at the same coordinates and to subtract a difference from the phase in each shot so that the difference becomes 0. Alternatively, the positional shift of the object is corrected on the basis of the phase difference distribution created from phase differences calculated at a plurality of coordinates. As the correction method, it is possible to use a navigator echo method disclosed in the specification of U.S. Patent No. 6541970, for example. Here, the distribution (phase shift map) of the phase difference is created using a reference navigation echo and each navigation echo. The phase is corrected by subtracting the phase difference, which is acquired from this phase shift map, from each echo signal.

In addition, if the waveforms of the first and second read gradient magnetic field pulses 701 and 702 are set such that the direction of the trajectory based on the rising parts a of the first and second read gradient magnetic field pulses 701 and 702 is different from the direction of the trajectory based on the falling parts b of both the gradient magnetic field pulses by 90° in the measurement space, body motion of the obj ect in two directions perpendicular to each other within the imaging plane can be detected using the data on these trajectories. As a result, it is possible to correct the body motion of the object in the two directions.

In addition, the waveforms $G_1$ and $G_2$ of the first and second read gradient magnetic field pulses 704 and 705 are adjusted so that the trajectories 710 on which the measurement space 500 is sampled in the spiral shape overlap each other partially between the shots. By comparing the data on the trajectories overlapping each other, a motion (that is, a rotational motion) in the circumferential direction can be detected and the motion can be corrected. In addition, since the spiral trajectories are made to overlap each other, imaging efficiency is lowered by the amount of overlap. However, according to the sampling method of the present embodiment, the central portion of the measurement space is not measured repeatedly compared with the multi-shot spiral method in the related art. Therefore, an image contrast reduction and the occurrence of blurring can be suppressed.

In addition, in the present embodiment, the above-described various kinds of correction are performed by the information processing system 7 as described above. The information processing system 7 realizes a correction unit that performs these correction processings by making the CPU 71 load a program, which is stored in advance in the storage device 72 or the external storage device 73, onto the memory and executing the program.

As described above, according to the present embodiment, since the waveforms $G_1$ and $G_2$ of the first and second read gradient magnetic field pulses 704 and 705 have the rising and falling parts a and b, a straight line portion is obtained on the trajectory of the measurement space. Using the data on this straight line, a mismatch of data between the shots can be corrected and reduced. Therefore, it is possible to reduce an artifact caused in an image in addition to the effects acquired in the first embodiment.

«Third embodiment»

Hereinafter, a third embodiment to which the invention is applied will be described. An MRI apparatus of the present embodiment is basically the same as that of each of the embodiments described above. In the present embodiment, a sampling method based on the data collection sequence part of the first or second embodiment is applied to the multi-echo method.

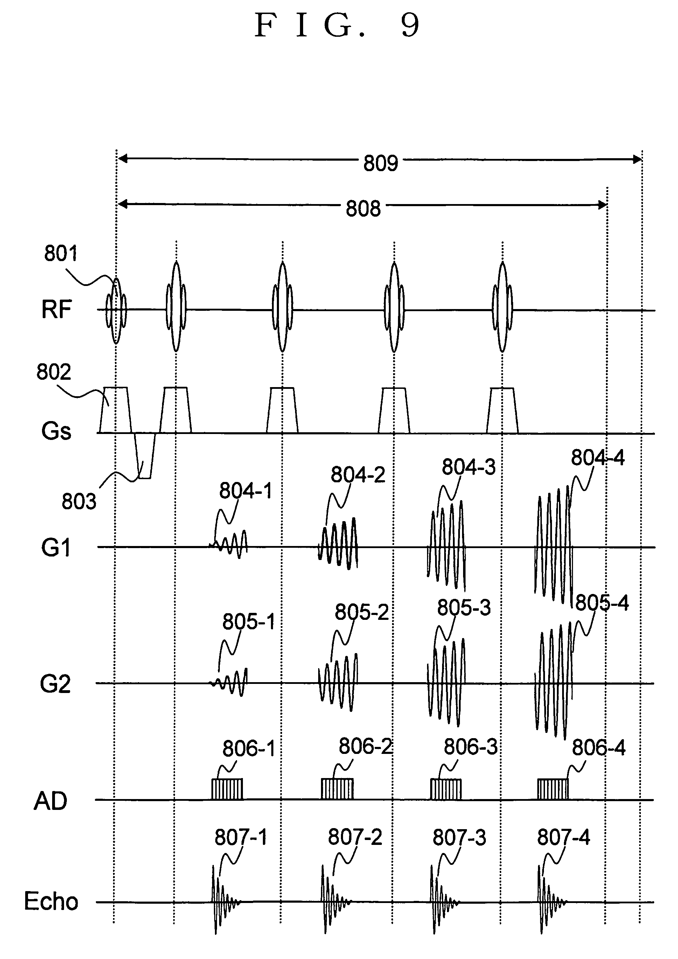

Fig. 9 is a pulse sequence when the sampling method of the present embodiment is applied to the multi-echo method. In this drawing, RF, Gs, G1, G2, AD, and echo indicate axes of an RF pulse, a slice gradient magnetic field, a read gradient magnetic field in a first direction, a read gradient magnetic field in a second direction, A/D conversion, and an echo signal, respectively. In addition, 801 is an RF pulse for excitation, 802 is a slice selection gradient magnetic field pulse, and 803 is a slice re-phase gradient magnetic field pulse.

Here, a pulse sequence in the case of a multi-echo method of 4 echoes of a single-shot method is illustrated. 804-1 to 804-4 are first read gradient magnetic field pulses, 805-1 to 805-4 are second read gradient magnetic field pulses, 806-1 to 806-4 are sampling windows, 807-1 to 807-4 are echo signals, and 808 is a repetition time (irradiation interval of the RF pulse 801).

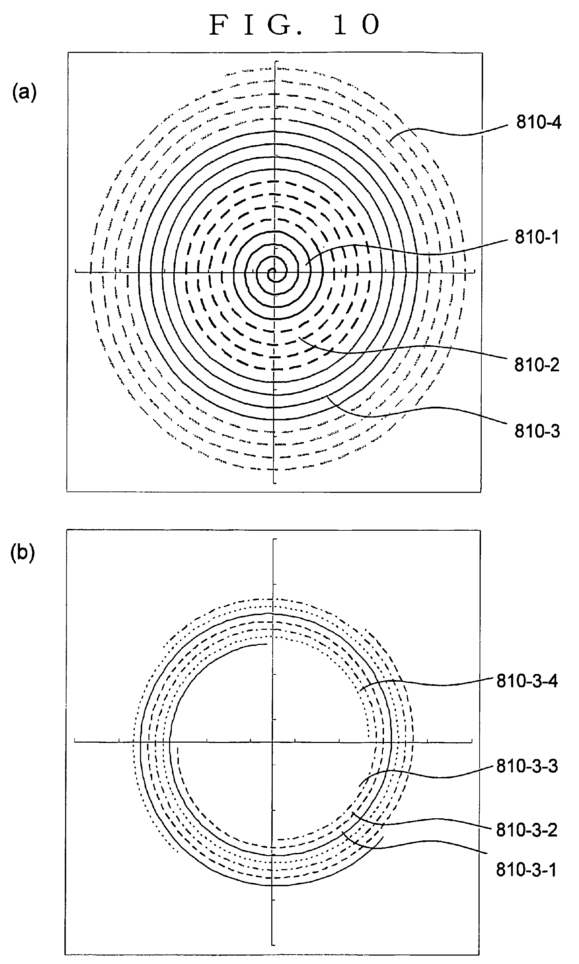

Fig. 10(a) shows a trajectory of the measurement space 500 based on the sampling method of the present embodiment. In the present embodiment, waveforms and sampling periods of the first and second read gradient magnetic field pulses 804-1 to 804-4 and the second read gradient magnetic field pulses 805-1 to 805-4 are set such that data items sampled from the four echo signals 807-1 to 807-4 are placed on trajectories 810-1 (solid line), 810-2 (dotted line), 810-3 (thin solid line), and 810-4 (thin dotted line) in four regions of the measurement space, respectively.

This can be realized by making the first read gradient magnetic field pulses 804-1 to 804-4 and the second read gradient magnetic field pulses 805-1 to 805-4 have the waveforms expressed by Expressions (7) and (8), respectively. Here, s is replaced with an echo number e (here $1 \leq e \leq 4$) which is uniquely given to the respective echo signals 807-1 to 807-4. Therefore, the waveforms of the first and second read gradient magnetic field pulses when acquiring an e-th echo signal of the present embodiment are expressed as $G_{M1}$ and $G_{M2}$ in the following Expression (11), respectively.

```
[Expression 11]
```

$$G_{M1}(t',e) = \eta\cos\zeta\tau'(t',e) - \eta\zeta\tau'(t',e)\sin\zeta\tau'(t',e)$$

$$G_{M2}(t',e) = \eta\sin\zeta\tau'(t',e) + \eta\zeta\tau'(t',e)\cos\zeta\tau'(t',e) \dots (11)$$

Here, $\tau'(t',e)$ is expressed by the following Expression (12).

[Expression 12]

$$\tau'(t',e) = \frac{(e-1)}{4} \times T + t' \qquad \dots (12)$$

In addition, Expression (12) shows a case where the number of echoes is 4. Generally, when the number of echoes is E (E is an integer of 1 or more and e is $1 \leq e \leq E$), the above-described Expression (12) is expressed by the following Expression (13).

[Expression 13]

$$\tau'(t',e) = \frac{(e-1)}{E} \times T + t' \qquad \dots (13)$$

In this case, data sampled from the echo signal 807 acquired at the echo time (TE) is placed on the trajectory 810-1 in a region near the central portion of the measurement space having a large effect on the image contrast. Then, the measurement space is filled in order of the trajectories 810-2 to 810-4 and in order close to the time TE at which the echo signal 807 is acquired. For example, in the case of acquiring a T1 weighted image, TE is set to a short time of about 10 msec and the measurement space is filled in the above order.

On the other hand, in the case of acquiring a T2 weighted image, TE is set to a long time. For this reason, when imaging efficiency is taken into consideration, an imaging sequence (waveforms of the first read gradient magnetic field pulses 804-1 to 804-4 and the second read gradient magnetic field pulses 805-1 and 805-2) is set such that the data is placed on the trajectories 810-4, 810-3, 810-2, and 810-1 in order in which the echo signals 807-1 to 807-4 are acquired.

Moreover, when the multi-shot method is combined, processing (shot) from irradiation of the RF pulse 801 to measurement of the echo signal 807-4 is repeated every repetition interval 808 while changing the strengths of the first read gradient magnetic field pulses 804-1 to 804-4 and the second read gradient magnetic field pulses 805-1 to 805-4 for each shot in the sequence shown in Fig. 9, so that data required for reconstructing one image for an image acquisition time 809 is sampled from the measured echo signals 807-1 to 807-4.

In this case, data sampled from all the echo signals 807-1 to 807-4 in respective shots is placed in regions divided in order set in advance for each shot. In addition, in each region, data sampled from the echo signals 807-1 to 807-4 acquired in each one shot is placed in an order set in advance. The imaging sequence is set so that the data arrangement is realized. This can be realized by making the first read gradient magnetic field pulses 804-1 to 804-4 and the second read gradient magnetic field pulses 805-1 to 805-4 have waveforms expressed as $G_1(t',e)$ and $G_2(t',e)$ in the following Expression (14), respectively.

[Expression 14]

$$G_1(t',e,s) = \cos(\varphi(s)) \times G_{M1}(t',e) - \sin(\varphi(s)) \times G_{M2}(t',e)$$

$$G_2(t',e,s) = \sin(\varphi(s)) \times G_{M2}(t',e) + \cos(\varphi(s)) \times G_{M2}(t',e)$$

$$\dots (14)$$

Here, e is an echo number (in this case, $1 \leq e \leq 4$), s is a shot number (in this case, $1 \leq s \leq 4$), and $\phi'(t',s)$ is expressed by the following Expression (15).

[Expression 15]

$$\varphi(s) = \frac{2\pi(s-1)}{4} \quad \ldots \quad (15)$$

In addition, Expression (15) shows a case where the number of shots is 4. Generally, when the number of shots is S (S is an integer of 1 or more and s is $1 \leq s \leq S$), the above Expression (15) is expressed by the following Expression (16).
[Expression 16]

$$\varphi(s) = \frac{2\pi(s-1)}{S} \quad \ldots \quad (16)$$

The data arrangement on the trajectory 810-3 filled in one shot when the number of shots is 4 and the number of echoes in each shot is 4 is illustrated. Data items sampled from the echo signals 807-1 to 807-4 acquired after application of one RF pulse 801 are placed in order, without overlapping, on the trajectories 810-3-1, 810-3-2, 810-3-3, and 810-3-4 sequentially from the start point of the spiral trajectory 810-3. This is the same for the other trajectories 810-1, 810-2, and 810-4.
By setting the sampling time and the waveforms of the first read gradient magnetic field pulses 804-1 to 804-4 and the second read gradient magnetic field pulse 805-1 to 805-4 in this way, data can also be placed on one spiral trajectory of the measurement space without overlapping in the multi-shot multi-echo method.
Through the above-described configuration, the effect of shortening the imaging time which is an advantage of the multi-echo method is also obtained in addition to the effects acquired in the first embodiment. In addition, when the spiral method and the multi-echo method are simply combined, all echo signals are placed in the central portion of the measurement space, there is a problem that the contrast is reduced. According to the present embodiment, however, data sampled from the echo signal acquired at the echo time (TE) can be placed in the central portion of the measurement space. For this reason, the contrast is not reduced. In addition, since the data sampled from the echo signal acquired at the desired time can also be placed in the central portion of the measurement space, an image with a desired contrast can be acquired.
In addition, also in the present embodiment, a signal for correction can be acquired without reducing the above-described effects by adding the rising part a and the falling part b, in the same manner as in the second embodiment. Therefore, the image quality can be further improved by performing correction.

«Fourth embodiment»

Next, a fourth embodiment to which the invention is applied will be described. An MRI apparatus of the present embodiment is basically the same as that of each of the embodiments described above. In the present embodiment, a function of changing an imaging parameter according to each division region (segment) in the measurement space where data sampled from an echo signal is placed is provided in addition to the configuration of any of the embodiments described above. In addition, an imaging parameter to be changed have an effect on an imaging time and the image quality.
In the MRI, sampling time ADtime of data is calculated by the following Expression (17) using the number of acquired data items SamplePoint and a sampling interval SamplePitch.
[Expression 17]

ADtime = SamplePoint × SamplePitch … (17)

In this case, the sampling interval SamplePitch is determined by a receiving bandwidth Rwidth at the time of sampling. That is, the sampling interval SamplePitch varies inversely with the receiving bandwidth BW (BW = $\alpha$/SamplePitch and $\alpha$ is a constant). Therefore, the relationship of the receiving bandwidth BW, the sampling time ADtime of data, and the number of acquired data items SamplePoint is expressed by the following Expression (18).

$$[\text{Expression 18}]$$

$$BW = \alpha \times SamplePoint / ADtime \quad \ldots (18)$$

That is, when acquiring the same spatial resolution, it is possible to shorten the sampling time ADtime by increasing the receiving bandwidth BW from Expression (18).

In order to put the required information of the spatial frequency in the receiving bandwidth BW, it is necessary to calculate the strengths of the first and second read gradient magnetic field pulses $G_1$ and $G_2$ according to the receiving bandwidth BW. Generally, the receiving bandwidth BW and the read gradient magnetic field pulse strength GI are proportional to each other (BW = $\beta$GI, and $\beta$ is a constant). Moreover, generally, the signal-to-noise ratio SNR decreases (BW=$\gamma$/SNR, and $\gamma$ is a constant) as the receiving bandwidth BW becomes large.

In each of the embodiments described above, the measurement space is divided into a plurality of segments, and each segment is filled in each shot. In this case, in the present embodiment, the above imaging parameter when executing the sequence is changed according to a segment and sampling is performed according to the data collection sequence part to execute imaging with the desired image quality and desired imaging time. For example, the number of acquired data items SamplePoint is fixed and the receiving bandwidth BW and the read gradient magnetic field pulse strength GI are changed to execute sampling at optimal sampling time ADtime.

Specifically, when acquiring an echo signal from which the data filled in a segment near the center of the measurement space (low spatial frequency region) is sampled, the receiving bandwidth BW is set to be narrow. Accordingly, data acquired from the echo signal with the good signal-to-noise ratio SNR is filled in the segment near the center. On the other hand, when acquiring an echo signal from which the data filled in a segment of the high spatial frequency region is sampled, the receiving bandwidth BW is set wide to shorten the sampling time ADtime.

Through such setting, when collecting a low spatial frequency region having a large effect on the quality of a reconstructed image, satisfactory data can be acquired although the sampling time ADtime becomes long. On the other hand, when collecting a high spatial frequency region, data can be acquired in a short time although the data has a low SNR. Therefore, a high-quality image can be acquired in the same imaging time, compared with a case where the receiving bandwidth BW is fixed. In addition, an image with almost the same quality can be acquired in a short imaging time.

In addition, by increasing the receiving bandwidth BW from Expression (18), it is possible to acquire a large number of data items in the same sampling time (increase the number of acquired data items SamplePoint). That is, the number of points SamplePoint of data sampled for each segment is changed by changing the receiving bandwidth BW and the read gradient magnetic field pulse strength GI according to each segment of the measurement space.

For example, when acquiring an echo signal from which the data filled in a segment near the center of the measurement space (low spatial frequency region) is sampled, the receiving bandwidth BW is set to be narrow. Accordingly, data acquired from the echo signal with the good signal-to-noise ratio SNR is filled in the segment near the center in the same manner as described above. On the other hand, when acquiring an echo signal from which the data filled in a segment of the high spatial frequency region is sampled, the receiving bandwidth BW is set wide to acquire a larger number of data items in the same sampling time.

Through such setting, when collecting a low spatial frequency region having a large effect on the quality of a reconstructed image, data with a satisfactory SNR can be acquired although the number of data items obtained in the same sampling time decreases and the number of times of repetition increases. On the other hand, when collecting a high spatial frequency region, it is possible to acquire a large number of data items in the same sampling time although the data has a low SNR. Accordingly, the number of times of repetition can be reduced. Therefore, a high-quality image can be acquired with the same number of times of repetition, compared with a case where the receiving bandwidth is fixed. In addition, an image with almost the same quality can be acquired with a small number of times of repetition.

In the present embodiment, imaging parameters, such as the receiving bandwidth BW, are changed for every region of the measurement space filled as described above in order to execute an optimal sequence. For this reason, the MRI apparatus 10 of the present embodiment includes an imaging parameter setting section. The imaging parameter setting section of the present embodiment generates a setting screen for imaging parameter setting and displays it on the display device 74. In addition, the imaging parameter setting section receives an imaging parameter, which is input through the input device 75 on the setting screen displayed on the display device 74, and sets it as an imaging parameter used when the pulse sequence is executed.

In addition, the imaging parameter setting section of the present embodiment is realized by the information processing system 7. That is, the information processing system 7 realizes the imaging parameter setting section by making the CPU 71 load a program, which is stored in advance in the storage device 72 or the external storage device 73, onto the memory and executing the program.

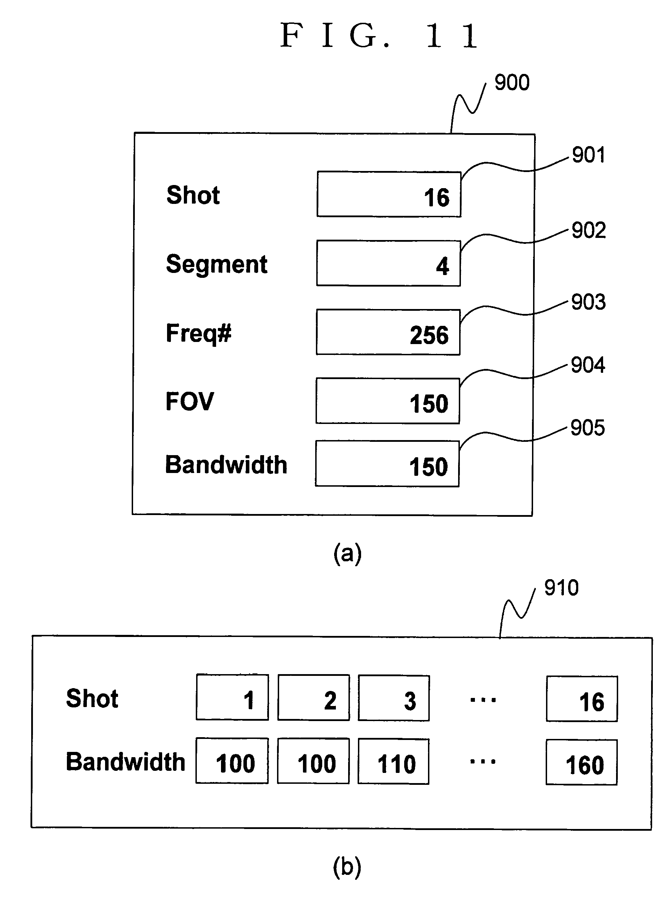

Here, the screen configuration of a setting screen 900 will be described. Fig. 11(a) is an example of a setting screen 900. Various imaging parameters are input and set in the MRI. Here, a screen configuration to which the number of shots Shot 901, the number of divided regions (segments) Segment 902, the number of frequency encodings Freq# 903, imaging field of view FOV 904, and a receiving bandwidth Bandwidth 905 as typical parameters having an effect on the imaging time and the image quality can be input is shown. In addition, the number of segments defines the number of divisions of one spiral trajectory in the measurement space acquired by the spiral method in the related art. On each divided trajectory, data sampled from one echo signal is placed.

The total number of echoes TotalEcho to be measured is expressed by the following Expression (19) using the number of shots Shot and the number of divided regions (segments) Segment.

$$[\text{Expression 19}]$$

$$\text{TotalEcho} = \text{Shot} \times \text{Segment} \dots (19)$$

In the single-shot method, 1 is set as the number of shots Shot 901. Then, parameters can be set similarly in both the spiral method of the multi-shot method and the spiral method of the single-shot method.

For example, the number of shots Shot 901 is set to 1, and the number of segments Segment 902 is set to be equal to the number of phase encoding in normal measurement (Cartesian sampling method). In this case, an image can be acquired in the same imaging time as in the case of normal measurement although the number of sampled echo signals is slightly increased.

In addition, an imaging parameter called a receiving bandwidth can be changed for every segment as described above. In order to meet this, for example, a sub-setting screen 910 shown in Fig. 11(b) may be set. For example, when a value of 2 or more is set as the Segment 902, the imaging parameter setting section displays the sub-setting screen 910 to receive setting of an imaging parameter for every segment. In addition, the sub-setting screen 910 may be displayed in response to an instruction from the user.

As described above, according to the present embodiment, the number of sampling points can be changed according to a region where the trajectory of the measurement space is disposed. Therefore, the degree of freedom of the pulse sequence is high. In addition, the receiving bandwidth can also be changed according to this region. Therefore, the signal-to-noise ratio can be set high. Thus, according to the present embodiment, measurement can be performed with good balance between an imaging period and the image quality since the imaging parameter setting section is provided, in addition to the effects acquired by each of the embodiments described above.

In addition, the invention is not limited to the contents disclosed in each of the embodiments described above, and various embodiments based on the spirit of the invention may be adopted. In each of the embodiments described above, small numbers are exemplified as the number of shots, the number of multi-echoes, the number of data points, and the like for explanation, these numbers are not limited to the above. In addition, although the case of using the gradient echo method is explained as an example of the imaging sequence part which determines the image contrast in each of the embodiments described above, a pulse sequence used as an imaging sequence of this part is not limited to this. Since a spiral method as a sampling module does not depend on the kind of a pulse sequence which forms an imaging sequence part, the spiral method may also be applied to a spin echo method, for example.

In addition, in each of the embodiments described above, the case where the data on one spiral trajectory in the measurement space is acquired sequentially from the center will be described as an example. Accordingly, data acquired in the early stage of the imaging time is placed at the center of the measurement space. In this case, the contrast and shape of an acquired image are determined by an echo signal acquired in the predetermined stage of the imaging time. However, the order of data acquisition is not limited to this. The order of data acquisition can be set arbitrarily according to the purpose.

For example, in an examination using a contrast medium, the contrast of an object to be photographed changes with elapsed time from injection of the contrast medium. For this reason, in the related art, images are continuously acquired using fluoroscopy measurement or the like, and diagnosis is performed on the basis of the contrast based on a difference in the arrival time of the contrast medium. In the case of such an application, data of the low spatial frequency region having a large effect on the contrast of an image may be acquired at high frequency.

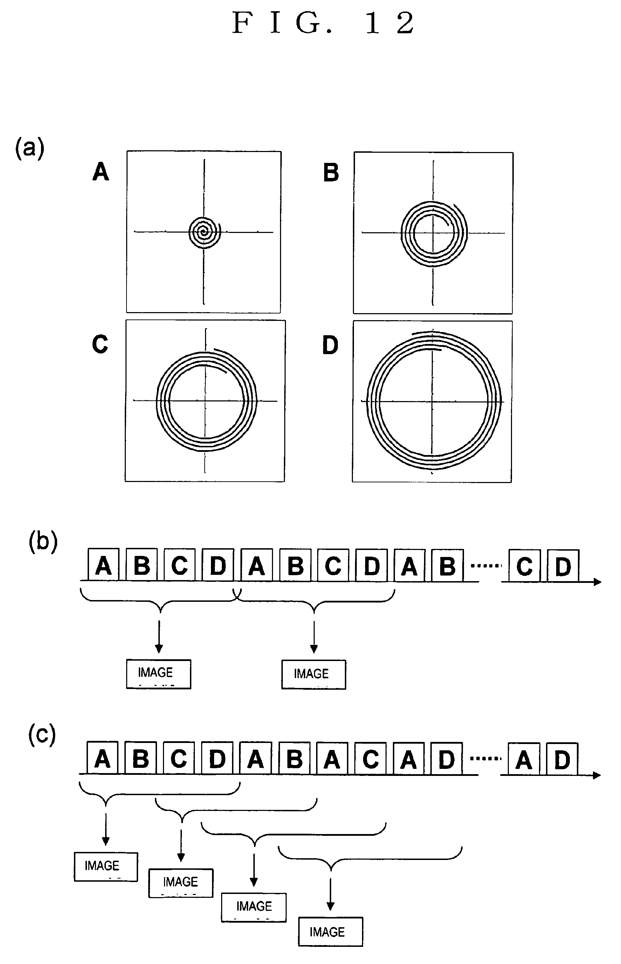

Fig. 12 is a view for explaining the order of data acquisition and reconstruction timing in an examination using the contrast medium as an example of each of the embodiments described above. Here, a case where the measurement space is divided into four regions (segments) as described above in order to perform measurement will also be described as an example. Fig. 12(a) is an example where the filled measurement space is divided into four regions set to A, B, C, and D, respectively.

Fig. 12(b) is an example of repeating the measurement of sampling four regions A to D shown in Fig. 12(a) in this order. In the example of Fig. 12(b), an image is reconstructed whenever all echo signals of the four regions A to D are acquired. As shown in Fig. 12(b), when the measurement of all regions is repeated in order of A to D each time, whenever each region is newly measured in the measurement space, the region is updated. For this reason, if echo signals are filled in the entire measurement space once, the echo signals are always filled in the measurement space thereafter. However, an echo signal of the region A which is a region of the central portion of the measurement space has a large effect on the contrast of an image. Accordingly, in the case of an image for which the contrast is important, a desired image is not acquired even if an image is reconstructed unless the region A is updated. Therefore, as shown in Fig. 12(b), when updating the four regions A to D (performing the measurement) at the same frequency, an image is reconstructed at update intervals of the region A, that is, whenever all regions are updated.

Fig. 12 (c) is an example of updating the region A, which is a region of the central portion of the measurement space, at high frequency for the four regions A to D shown in Fig. 12(a). In this example, after acquiring the regions A to D of the entire measurement space first, the read gradient magnetic field pulses $G_1$ and $G_2$ are controlled so as to acquire the region A at a frequency of once every two times. By performing the measurement in this way, an image can be generated for every two measurements.

In addition, although an example of the spiral method of performing sampling outward from the center of the measurement space has been illustrated in each of the embodiments described above, the invention can also be applied to the spiral method of performing sampling toward the center from the outside of the measurement space. In order to fill the measurement space when performing sampling toward the center from the outside of the measurement space, it is preferable to calculate the time τ(t',s) in the opposite direction in the calculation of Expression (7). That is, τ(t',s) is expressed by the following Expression (20).

[Expression 20]

$$\tau(t',s) = \frac{(s-1)}{4} \times T + \left(\frac{T}{4} - t'\right) \quad \ldots \ (20)$$

In this case, data acquired at the end of the imaging time is placed at the center of the measurement space. Accordingly, the contrast and shape of an image are determined by an echo signal acquired at the end of the imaging time.

In addition, a spiral method of performing sampling in the unspecified direction of the measurement space, for example, a spiral method in a three-dimensional space, a spiral method of performing sampling outward from the center of the measurement space and then performing sampling for returning to the center again, or the like can be applied similarly.

Reference Signs List

| | |
|---|---|
| 1: | object |
| 2: | static magnetic field generation system |
| 3: | gradient magnetic field generation system |
| 4: | sequencer |
| 5: | signal transmission system |
| 6: | signal receiving system |
| 7: | information processing system |
| 10: | MRI apparatus |
| 31: | gradient magnetic field coil |
| 32: | gradient magnetic field power source |

| | |
|---|---|
| 51: | transmission coil |
| 52: | synthesizer |
| 53: | modulator |
| 54: | high frequency amplifier |
| 61: | receiving coil |
| 62: | amplifier |
| 63: | quadrature phase detector |
| 64: | A/D converter |
| 71: | CPU |
| 72: | storage device |
| 73: | external storage device |
| 74: | display device |
| 75: | input device |
| 104-1: | first read gradient magnetic field pulse |
| 104-2: | first read gradient magnetic field pulse |
| 104-3: | first read gradient magnetic field pulse |
| 104-4: | first read gradient magnetic field pulse |
| 105-1: | second read gradient magnetic field pulse |
| 105-2: | first read gradient magnetic field pulse |
| 105-3: | first read gradient magnetic field pulse |
| 105-4: | first read gradient magnetic field pulse |
| 110-1: | trajectory |
| 110-2: | trajectory |
| 110-3: | trajectory |
| 110-4: | trajectory |
| 201: | RF pulse for excitation |
| 202: | slice selection gradient magnetic field pulse |
| 203: | slice re-phase gradient magnetic field pulse |
| 204: | first read gradient magnetic field pulse |
| 205: | second read gradient magnetic field pulse |
| 206: | sampling window |
| 207: | echo signal |
| 208: | repetition time |
| 209: | image acquisition time |
| 210: | linear trajectory |
| 301: | RF pulse for excitation |
| 302: | slice selection gradient magnetic field pulse |
| 303: | slice re-phase gradient magnetic field pulse |
| 304: | first read gradient magnetic field pulse |
| 305: | second read gradient magnetic field pulse |
| 306: | sampling window |
| 307: | echo signal |
| 308: | repetition time |
| 309: | image acquisition time |
| 310: | spiral trajectory |
| 311-1: | spiral trajectory |
| 311-2: | spiral trajectory |
| 311-3: | spiral trajectory |
| 311-4: | spiral trajectory |
| 400: | relaxation curve |
| 500: | measurement space |
| 704-1: | first read gradient magnetic field pulse |
| 704-2: | first read gradient magnetic field pulse |
| 704-3: | first read gradient magnetic field pulse |
| 704-4: | first read gradient magnetic field pulse |
| 705-1: | second read gradient magnetic field pulse |
| 705-2: | first read gradient magnetic field pulse |
| 705-3: | first read gradient magnetic field pulse |

705-4:     first read gradient magnetic field pulse
710-1:     trajectory
710-2:     trajectory
710-3:     trajectory
710-4:     trajectory
801:       RF pulse for excitation
802:       slice selection gradient magnetic field pulse
803:       slice re-phase gradient magnetic field pulse
808:       repetition time
809:       image acquisition time
804-1:     first read gradient magnetic field pulse
804-2:     first read gradient magnetic field pulse
804-3:     first read gradient magnetic field pulse
804-4:     first read gradient magnetic field pulse
805-1:     second read gradient magnetic field pulse
805-2:     second read gradient magnetic field pulse
805-3:     second read gradient magnetic field pulse
805-4:     second read gradient magnetic field pulse
806-1:     sampling window
806-2:     sampling window
806-3:     sampling window
806-4:     sampling window
807-1:     echo signal
807-2:     echo signal
807-3:     echo signal
807-4:     echo signal
810-1:     trajectory
810-2:     trajectory
810-3:     trajectory
810-3-1:   trajectory
810-3-2:   trajectory
810-3-3:   trajectory
810-3-4:   trajectory
810-4:     trajectory
900:       setting screen
901:       number of shots
902:       number of segments
903:       number of frequency encodings
904:       imaging field of view
905:       receiving bandwidth
910:       setting screen

**Claims**

1. A magnetic resonance imaging apparatus comprising:

   a high frequency magnetic field irradiating unit that irradiates a high frequency magnetic field causing nuclear magnetic resonance in nuclear spins in an object;
   a data collector that detects an echo signal irradiated by the nuclear magnetic resonance while applying a read gradient magnetic field and places the echo signal as data in a measurement space; and
   a controller that controls operations of the high frequency magnetic field irradiating unit and the data collector, wherein the controller controls the data collector to collect data, which is placed on one spiral trajectory heading outward from the center of the measurement space, by detection of the plurality of echo signals.

2. The magnetic resonance imaging apparatus according to claim 1,
   wherein the controller controls a waveform of the read gradient magnetic field such that data collected from each of the echo signals by the data collector is placed approximately continuously, without overlapping, on the one spiral trajectory in order of acquisition of the echo signals.

3. The magnetic resonance imaging apparatus according to claim 2,
wherein the controller controls a waveform of the read gradient magnetic field such that data collected from each of the echo signals by the data collector is placed on the one spiral trajectory in order from the center of the measurement space to the outside.

4. The magnetic resonance imaging apparatus according to claim 2,
wherein the controller controls a waveform of the read gradient magnetic field such that data collected from each of the echo signals by the data collector is placed on the one spiral trajectory in order from the outside of the measurement space to the center.

5. The magnetic resonance imaging apparatus according to claim 2,
wherein the controller controls a waveform of the read gradient magnetic field such that the data collector further collects, as data for correction, data placed on two linear trajectories, which connect the center of the measurement space and start and end points of the spiral trajectory on which data collected from corresponding echo signals is placed, in units of the plurality of echo signals.

6. The magnetic resonance imaging apparatus according to claim 5,
wherein the controller controls a waveform of the read gradient magnetic field such that the linear trajectory connecting the start point and the center to each other and the linear trajectory connecting the end point and the center to each other are perpendicular to each other on the measurement space.

7. The magnetic resonance imaging apparatus according to claim 1,
wherein the controller controls a waveform of the read gradient magnetic field such that data collected from each of the echo signals by the data collector is placed on the one spiral trajectory in order from the center of the measurement space to the outside or in order from the outside to the center of the measurement space and is also placed on the trajectory so as to partially overlap each other, and sets the data disposed so as to overlap each other as data for correction.

8. The magnetic resonance imaging apparatus according to claim 5, further comprising:

a signal correction unit that corrects discontinuities between two successive echo signals using the data for correction.

9. The magnetic resonance imaging apparatus according to claim 1,
wherein the controller controls an operation of the data collector so as to collect data along a trajectory of a region in a predetermined range with a different distance from the center of the measurement space, which is the one spiral trajectory, for each of the echo signals.

10. The magnetic resonance imaging apparatus according to claim 1,
wherein the controller performs control such that a plurality of echo signals are acquired for one irradiation of a high frequency magnetic field for excitation which excites magnetization in the object.

11. The magnetic resonance imaging apparatus according to claim 1, further comprising:

a parameter change unit that changes an imaging parameter, which has an effect on an imaging time or the quality of a reconstructed image, for every irradiation of a high frequency magnetic field for excitation which excites magnetization in the object.

12. The magnetic resonance imaging apparatus according to claim 11, further comprising:

an input unit that receives a designation of the imaging parameter for each high frequency magnetic field for excitation.

13. The magnetic resonance imaging apparatus according to claim 11,
wherein the imaging parameter is at least one of the number of data items collected for each high frequency magnetic field for excitation by the data collector, a receiving band, and an application interval of the high frequency magnetic field for excitation.

**14.** A magnetic resonance imaging apparatus comprising:

a high frequency magnetic field irradiating unit that irradiates a high frequency magnetic field causing nuclear magnetic resonance in nuclear spins in an object placed in a static magnetic field;
a gradient magnetic field application unit that applies a gradient magnetic field to the static magnetic field;
a detector that detects an echo signal irradiated by the magnetic resonance;
a data placement unit that places the detected echo signal in a measurement space as data;
an image reconstruction unit that reconstructs an image from the data placed in the measurement space; and
a controller that controls operations of the high frequency magnetic field irradiating unit, the gradient magnetic field application unit, the detector, the data placement unit, the image reconstruction unit, and filling of the measurement space by the plurality of echo signals,
wherein the controller causes the gradient magnetic field application unit to apply first and second gradient magnetic fields with waveforms, which vibrate and have amplitudes increasing gradually or decreasing gradually and in which a strength at a start point is the same as a strength at an end point at the time of last echo signal detection, and controls measurement of the measurement space in a spiral shape by applying the first and second gradient magnetic fields when the detector detects each echo signal.

**15.** A magnetic resonance imaging method comprising:

a data collection step of collecting data, which is placed on one spiral trajectory heading outward from the center of a measurement space, so as to fill the measurement space without overlapping by detecting a plurality of echo signals irradiated by nuclear magnetic resonance; and
an image reconstruction step of reconstructing an image from the data of the measurement space collected in the data collection step.

# F I G .  1

STORAGE DEVICE 72

EXTERNAL STORAGE DEVICE 73

DISPLAY DEVICE 74

INPUT DEVICE 75

7

71

CPU

10

4 SEQUENCER

64 A/D

63

SYNTHESIZER

MODULATOR 53

32 GRADIENT MAGNETIC FIELD POWER SOURCE

QUADRATURE PHASE DETECTOR

52

54

GRADIENT MAGNETIC FIELD COIL

51 HIGH FREQUENCY COIL

31

62

61 HIGH FREQUENCY COIL

1

31 GRADIENT MAGNETIC FIELD COIL

5 SIGNAL TRANSMISSION SYSTEM

3 GRADIENT MAGNETIC FIELD GENERATION SYSTEM

6 SIGNAL RECEIVING SYSTEM

2 STATIC MAGNETIC FIELD GENERATION SYSTEM

# F I G. 2

F I G. 3

# F I G .   4

# F I G .  5

(a)

500

311-2

311-1

311-3

311-4

(b)

304-1

305-1

304-2

305-2

304-3

305-3

304-4

305-4

F I G. 6

# F I G . 7

# F I G .  8

SIGNAL
STRENGTH

400

A          B                    TIME

# F I G .   9

# F I G. 1 0

(a)

810-4

810-1

810-2

810-3

(b)

810-3-4

810-3-3

810-3-2

810-3-1

# F I G. 1 1

900

| | 901 |
|---|---|
| **Shot** | 16 |
| **Segment** | 4 |
| **Freq#** | 256 |
| **FOV** | 150 |
| **Bandwidth** | 150 |

901
902
903
904
905

(a)

910

| **Shot** | 1 | 2 | 3 | ··· | 16 |
|---|---|---|---|---|---|
| **Bandwidth** | 100 | 100 | 110 | ··· | 160 |

(b)

# F I G. 1 2

(a)

(b)

(c)

**EP 2 454 992 A1**

| INTERNATIONAL SEARCH REPORT | | International application No. |
|---|---|---|
| | | PCT/JP2010/061391 |

A. CLASSIFICATION OF SUBJECT MATTER
*A61B5/055*(2006.01)i

According to International Patent Classification (IPC) or to both national classification and IPC

B. FIELDS SEARCHED

Minimum documentation searched (classification system followed by classification symbols)
A61B5/055

Documentation searched other than minimum documentation to the extent that such documents are included in the fields searched
| Jitsuyo Shinan Koho | 1922-1996 | Jitsuyo Shinan Toroku Koho | 1996-2010 |
| Kokai Jitsuyo Shinan Koho | 1971-2010 | Toroku Jitsuyo Shinan Koho | 1994-2010 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | JP 8-56929 A (Philips Electronics N.V.), 05 March 1996 (05.03.1996), | 1-3,9,10,14, 15 |
| Y | paragraphs [0011], [0041] & US 5604434 A & EP 695952 A1 | 4 |
| Y | JP 2009-50738 A (National Institute of Advanced Industrial Science and Technology), 12 March 2009 (12.03.2009), paragraph [0022]; fig. 8 (Family: none) | 4 |
| A | JP 2002-143117 A (GE Medical Systems Global Technology Co., L.L.C.), 21 May 2002 (21.05.2002), paragraphs [0006], [0007] (Family: none) | 1-15 |

☒ Further documents are listed in the continuation of Box C.  ☐ See patent family annex.

| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |
|---|---|

| Date of the actual completion of the international search<br>16 July, 2010 (16.07.10) | Date of mailing of the international search report<br>03 August, 2010 (03.08.10) |
|---|---|
| Name and mailing address of the ISA/<br>Japanese Patent Office | Authorized officer |
| Facsimile No. | Telephone No. |

Form PCT/ISA/210 (second sheet) (July 2009)

33

**INTERNATIONAL SEARCH REPORT**

International application No.

PCT/JP2010/061391

C (Continuation).   DOCUMENTS CONSIDERED TO BE RELEVANT

| Category* | Citation of document, with indication, where appropriate, of the relevant passages | Relevant to claim No. |
|---|---|---|
| A | JP 9-299345 A  (GE Yokogawa Medical Systems, Ltd.), 25 November 1997 (25.11.1997), entire text; all drawings (Family: none) | 1-15 |
| A | V.Olafsson, et al., "Dynamic Updates of R2* and Field Map in fMRI Using a Spiral-In Quick-Spiral-Out K-Space Trajectory", Proc. Intl. Soc. Mag. Reson. Med., 2006, p2838 | 1-15 |
| A | C.B.AHN, et al., "High-Speed Spiral-Scan Echo Planar NMR Imaging-I", IEEE TRANSACTIONS ON MEDICAL IMAGING, 1986.03, VOL. MI-5, NO. 1, p2-p7 | 1-15 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 6541970 B

### Non-patent literature cited in the description

- **G. H. Glover.** Projection Reconstruction Techniques for Reduction of Motion Effects in MRI. *Magnetic Resonance in Medicine,* 1992, vol. 28, 275-289
- **C. B. Ahn.** High-Speed Spiral-Scan Echo Planar NMR Imaging-I. *IEEE Trans. Med. Imag,* 1986, vol. MI-5 (1), 1-7
- **J. I Jackson.** Selection of a Convolution Function for Fourier Inversion Using Gridding. *IEEE Trans. Med. Imaging,* 1991, vol. 10, 473-478